(19) Europäisches Patentamt
European Patent Office
Office européen des brevets

(11) **EP 2 600 391 A1**

(12) **EUROPEAN PATENT APPLICATION**
published in accordance with Art. 153(4) EPC

(43) Date of publication:
**05.06.2013 Bulletin 2013/23**

(51) Int Cl.:
***H01L 21/304*** (2006.01)   ***C09J 7/02*** (2006.01)
***H01L 21/301*** (2006.01)

(21) Application number: **11812085.6**

(22) Date of filing: **28.07.2011**

(86) International application number:
**PCT/JP2011/004287**

(87) International publication number:
**WO 2012/014487 (02.02.2012 Gazette 2012/05)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **26.04.2011 JP 2011098199
28.07.2010 JP 2010169787**

(71) Applicant: **Du Pont-Mitsui Polychemicals Co., Ltd.
Tokyo 105-7117 (JP)**

(72) Inventors:
• **AOYAMA, Masataka
Ichihara,
Chiba 200-0108 (JP)**

• **MORIMOTO, Atsushi
Ichihara,
Chiba 299-0108 (JP)**
• **ICHINOSEKI, Chikara
Ichihara,
Chiba 299-0108 (JP)**
• **HIRONAKA, Yoshitaka
Ichihara,
Chiba 299-0108 (JP)**

(74) Representative: **Gulde Hengelhaupt Ziebig &
Schneider
Patentanwälte - Rechtsanwälte
Wallstrasse 58/59
10179 Berlin (DE)**

(54) **LAMINATE FILM, AND FILM FOR USE IN PRODUCTION OF SEMICONDUCTOR COMPRISING SAME**

(57)    The purpose of the present invention is to provide a laminate film which has excellent heat resistance and stress relaxing properties and is suitable as a component member for a film that is used for the production of a semiconductor. The present invention relates to a laminate film (10) having a laminated structure composed of at least two layers including the outermost layer (6), wherein the outermost layer (6) comprises a thermoplastic resin composition containing a thermoplastic resin having a melting point of 98°C or higher, at least one layer (a second layer (3)) other than the outermost layer (6) comprises a resin composition containing an ethylene-(unsaturated carboxylic acid) copolymer having an unsaturated carboxylic acid content of 17 mass% or more or an ionomer of the copolymer.

FIG. 1

## Description

Technical Field

The present invention relates to a laminate film and a film used for manufacturing semiconductor using the same.

Background Art

A process for manufacturing semiconductor devices such as IC typically involves the step of grinding the back surface of a patterned semiconductor wafer for the thinning the semiconductor wafer. During the back grinding step, an adhesive film (or back grinding film) is attached to the patterned surface of the semiconductor wafer to protect the patterned surface from contamination and/or the like as well as to preserve the thinned semiconductor wafer.

After the back grinding step, a dicing step is typically performed wherein an elastic wafer processing film (or dicing film) is bonded to the ground back surface of the semiconductor wafer and then the semiconductor wafer is diced into individual chips.

Semiconductor wafers made of silicon or other metal are brittle and therefore suffer from the problem of being easily damaged by the stress loaded during grinding and/or by the stress loaded when dicing the semiconductor wafer into individual chips. It is therefore necessary for the back grinding film and the dicing film to have stress relaxation properties allowing the relaxation of the stress loaded on the semiconductor wafer during grinding and/or dicing, to prevent possible damages to the semiconductor wafer.

In addition, upon back-surface grinding of a semiconductor wafer, frictional heat is generated. Accordingly, when performing the back-surface grinding with a heat-sensitive back grinding film being attached to the patterned surface, it may be difficult to detach the back grinding film after completion of grinding. Additionally, recent in-line processes deliver semiconductor wafers to a dicing process with a back grinding film being attached on the surface, and attach a dicing film to the back surface (ground surface) of the semiconductor wafer under heating conditions. Thus, using a heat-sensitive back grinding film or dicing film can result in, for example, softening of the film due to heat, so that the film cannot be easily detached or can stick to a working table (die). Furthermore, if deformation such as distortion or warpage due to heat occurs on these films, the thinned semiconductor wafer can be deformed. Thus, these films are required to have heat resistance, in addition to stress relaxation properties mentioned above.

As a specific example of films for semiconductor manufacturing known in the art, PTL 1 discloses an adhesive tape for back grinding, which includes a single-layer base film made of a mixture of an ethylene-vinyl acetate copolymer (EVA) and a polyolefin resin having a melting point of 100°C or higher (see PTL 1). Another known example includes a wafer processing tape that includes a base film having a bottom layer composed of a thermoplastic resin having a Vicat softening point of 80°C or higher and a layer other than the bottom layer, which is composed of a thermoplastic resin having a Vicat softening point of 50°C or higher to less than 80°C (see, e.g., PTL 2).

Citation List

Patent Literature

PTL 1: Japanese Patent No. 4351487
PTL 2: Japanese Patent Application Laid-Open No. 2009-231700

Summary of Invention

Technical Problems

The adhesive tape for back grinding disclosed in PTL 1 is intended to suppress damage to semiconductor wafers by forming the base film using a material containing flexible EVA to absorb external forces. The wafer processing tape disclosed in PTL 2 is intended to improve flexibility as well as to prevent, for example, adhesion to a die by using a laminated structure having a plurality of layers composed of materials having different Vicat softening points. However, in recent years, along with further thinning of semiconductor wafers (e.g., as small as 50 to 100 $\mu$m), higher stress relaxation properties have been required to prevent damage to semiconductor wafers. Additionally, in response to the aforementioned in-line processes, the films for semiconductor manufacturing have also been required to have such properties that may prevent adhesion to a die. The properties allowing, for example, the prevention of adhesion to a die, i.e., properties that do not cause excessive softening even by heating (i.e., heat resistance).

The present invention has been accomplished in view of the foregoing problems pertinent in the art. It is an object of the present invention to provide a laminate film excellent in heat resistance and stress relaxation properties, and is suitable as a component of a film for semiconductor manufacturing. It is another object of the present invention to provide a film for semiconductor manufacturing, which can be used suitably in a back grinding step and a dicing step for semiconductor wafers.

Solution to Problems

Specifically, the present invention provides laminate films and films for semiconductor manufacturing given below.

[1] A laminate film including a laminated structure composed of at least two layers including an outermost layer, wherein the outermost layer comprises a thermoplastic resin composition containing a thermoplastic resin having a melting point of 98°C or higher, and at least one layer other than the outermost layer comprises a resin composition containing at least one of an ethylene-unsaturated carboxylic acid copolymer having an unsaturated carboxylic acid content of 17wt% or more and an ionomer of the copolymer.

[2] The laminate film according to [1], wherein the resin composition contained in the at least one layer other than the outermost layer contains an ionomer of the ethylene-unsaturated carboxylic acid copolymer.

[3] The laminate film according to [2], wherein the thermoplastic resin has a Vicat softening temperature of 70°C or higher.

[4] The laminate film according to [2] or [3], wherein the thermoplastic resin is one of a polyolefin and a polyester elastomer.

[5] The laminate film according to any of [2] to [4], wherein a ratio of thickness (X) of the outermost layer to thickness (Y) of the at least one layer other than the outermost layer is 5/95 to 45/55.

[6] The laminate film according to [1], wherein the resin composition contains the ethylene-unsaturated carboxylic acid copolymer.

[7] The laminate film according to [6], wherein an MFR of the thermoplastic resin, as measured at 190°C under a load of 2160 g, is 15 g/10 min or more.

[8] The laminate film according to [6] or [7], wherein an MFR of the ethylene-unsaturated carboxylic acid copolymer, as measured at 190°C under a load of 2160 g, is 15 g/10 min or more.

[9] The laminate film according to any of [6] to [8], wherein a ratio of thickness (X) of the outermost layer to total thickness (Y) of layers containing the ethylene-unsaturated carboxylic acid copolymer is 5/95 to 60/40.

[10] The laminate film according to [9], wherein a ratio of a MFR-1 as measured at 190°C under a load of 2160 g of the thermoplastic resin composition forming the outermost layer to a MFR-2 as measured at 190°C under a load of 2160 g of the ethylene-unsaturated carboxylic acid copolymer is in a range of 0.2 to 5.

[11] The laminate film according to any of [6] to [10], wherein the thermoplastic resin composition forming the outermost layer includes polyethylene.

[12] The laminate film according to any of [6] to [10], wherein the thermoplastic resin composition forming the outermost layer includes polypropylene.

[13] A film for semiconductor manufacturing, including the laminate film according to any of the [1] to [12] and an adhesive layer disposed on a surface of a layer positioned on an opposite side of the outermost layer of the laminate film.

[14] The film for semiconductor manufacturing according to [13], which is a back grinding film.

[15] The film for semiconductor manufacturing according to [13], which is a dicing film.

Advantageous Effects of Invention

The laminate film of the claimed invention has excellent heat resistance and stress relaxation properties. Therefore, the laminate film of the claimed invention is suitable as a component of a film for semiconductor manufacturing used in the back grinding step, dicing step and/the like of semiconductor wafers.

The film for semiconductor manufacturing of the claimed invention has excellent heat resistance and stress relaxation properties. Therefore, the film for semiconductor manufacturing of the claimed invention is suitable as a film for semiconductor manufacturing used in the back grinding step, dicing step and/or the like of semiconductor wafers.

Brief Description of Drawings

FIG. 1 is a cross-sectional view schematically illustrating an embodiment of a laminate film of the claimed invention; and

FIG. 2 is a cross-sectional view schematically illustrating an embodiment of a film for semiconductor manufacturing of the claimed invention.

Description of Embodiments

1. Laminate Film

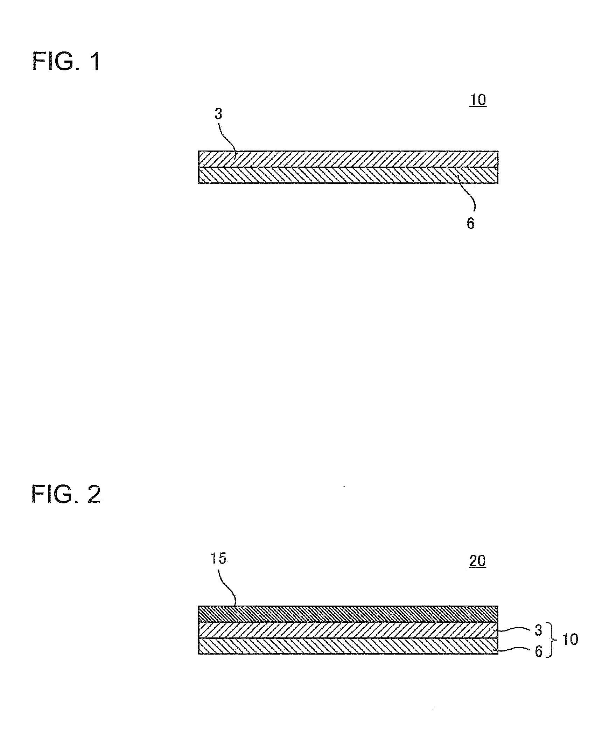

FIG. 1 is a cross-sectional view schematically illustrating an embodiment of a laminate film of the claimed invention. As shown in FIG. 1, laminate film 10 of the present embodiment has a laminated structure in which outermost layer 6 and second layer 3 are laminated. Outermost layer 6 is formed of a thermoplastic resin composition containing a thermoplastic resin having a melting point of 98°C or higher. In addition, second layer 3 is formed of a resin composition containing at least one of an ethylene-unsaturated carboxylic acid copolymer having an unsaturated carboxylic acid content of 17wt% or more and an ionomer of the ethylene-unsaturated carboxylic acid copolymer. With this laminated structure, the laminate film achieves both heat resistance and stress relaxation properties.

Accordingly, when an adhesive layer is disposed on a surface of second layer 3 to use the laminate film as a film for semiconductor manufacturing, the film is not excessively softened by heat and does not adhere to a working table (die), so that problems including the occurrence of deformation such as distortion or warping are less likely to occur. Hereinafter, the structure of each layer will be described.

(Layer Other Than Outermost Layer (Second Layer))

The second layer is a layer other than the outermost layer described later. The second layer may be composed of two or more layers. In addition, the outermost layer and the second layer may be in direct contact with each other, or different layer(s) may be interposed between the outermost layer and the second layer.

The second layer is formed of a resin composition containing at least one of an ethylene-unsaturated carboxylic acid copolymer having an unsatured carboxylic acid content of 17wt% or more (hereinafter may be simply referred to as "copolymer") and an ionomer of the ethylene-unsaturated carboxylic acid copolymer having the unsatured carboxylic acid content of 17wt% or more (hereinafter may be simply referred to as "ionomer").

The ionomer of the ethylene-unsaturated carboxylic acid copolymer refers to an ionomer in which some or all of the carboxyl groups of the ethylene-carboxylic acid copolymer is neutralized with metals (ions). Herein, a compound in which at least some of the acid groups of the ethylene-unsaturated carboxylic acid copolymer are neutralized with metal (ions) is defined as the ionomer, and a compound in which no acid groups of the ethylene-unsaturated carboxylic acid copolymer are neutralized with metals (ions) is defined as the copolymer.

An ethylene-unsaturated carboxylic acid copolymer that has at least a specific level of unsaturated carboxylic acid content is considered to have more hydrogen bond sites and therefore more structural units pseudo-crosslinked by intermolecular hydrogen bonding, in comparison to copolymers having less than the specific level of unsaturated carboxylic acid. Moreover, an ionomer of the ethylene-unsaturated carboxylic acid copolymer having at least the specific level of unsaturated carboxylic acid content has more sites pseudo-crosslinked by metal ions, i.e., more ion aggregates are formed, in comparison to ionomers having less than the specific level of unsaturated carboxylic acid content.

Thus, it is suggested that the second layer formed of the resin composition containing the ethylene-unsaturated carboxylic acid copolymer having at least the specific level of unsaturated carboxylic acid content or the ionomer thereof shows a tendency to absorb stress owing to their structure.

Forms of the ethylene-unsaturated carboxylic acid copolymer forming the above-described copolymer or ionomer thereof include graft copolymer, random copolymer, and block copolymer, with random copolymer being preferable as it can have a higher level of unsaturated carboxylic acid content. By increasing the unsaturated carboxylic acid content in the above-described copolymer, it is expectable that structural units pseudo-crosslinked by intermolecular hydrogen bonding will increase in number. Additionally, by increasing the unsaturated carboxylic acid content in the above-described ionomer, it is expectable that structural units pseudo-crosslinked by metal ions will increase in number.

The unsaturated carboxylic acid content in the copolymer or the ionomer in the resin composition forming the second layer is preferably 17wt% or more, and more preferably 19wt% or more, from the viewpoint of improving the stress relaxation properties of the laminate film. It is more preferable as the unsaturated carboxylic acid content in the copolymer is higher. However, an upper limit value of the unsaturated carboxylic acid content in the ionomer is preferably approximately 30wt%.

Examples of the unsaturated carboxyl acid forming the copolymer or ionomer described above include acrylic acid, methacrylic acid, fumaric acid, maleic acid, and maleic acid monoethyl, with acrylic acid and methacrylic acid being preferable. Two or more of the unsaturated carboxylic acids may be combined.

The ethylene-unsaturated carboxylic acid copolymer forming the above-described copolymer or ionomer may include other monomer component(s) other than ethylene and unsatured carboxylic acids. Examples of the other monomer component(s) include (meth)acrylic esters such as methyl methacrylate, ethyl methacrylate, isobutyl methacrylate, and butyl methacrylate, and vinyl acetate.

The above-described ionomer is preferably an ionomer in which any desired number of carboxyl groups of the ethylene-unsaturated carboxylic acid copolymer is crosslinked (neutralized) with ions of an alkali metal such as lithium (Li), sodium (Na), potassium (K), or rubidium (Rb) or with ions of a metal other than alkali metal, such as zinc (Zn) or magnesium (Mg). The ratio of the crosslinked carboxyl groups in the ionomer is preferably 1 to 90 mol%, and more preferably 3 to 70 mol%.

The melt flow rate (MFR) of the above-described ionomer, as measured at 190°C under a load of 2.16 kg in accordance with JIS K-6721, is preferably 0.1 to 50 g/min, and more preferably 0.5 to 20 g/min. The resin composition containing the ionomer having an MFR that falls within any of the above-described ranges exhibits good processability, e.g., by extrusion molding, and has the advantage of, for example, being easily processed into film.

Meanwhile, the melt flow rate (MFR) of the above-described copolymer, as measured at 190°C under a load of 2.16 kg in accordance with JIS K-7210, is preferably 15 to 500 g/min, and more preferably 25 to 300 g/min. The ethylene-unsaturated carboxylic acid copolymer having an MFR falling within any of the above-described range is excellent in stress relaxation properties and also exhibits good processability, e.g., by extrusion molding at low temperatures, so that the copolymer has the advantage of, for example, being easily processed into sheet. On the other hand, when the ethylene-unsaturated carboxylic acid copolymer has a small MFR value, i.e., when the molecular weight thereof is too large, the stress relaxation properties of the ethylene-unsaturated carboxylic acid copolymer are reduced, which is not preferable.

The thickness of the second layer is not specifically limited, but is preferably 50 to 150 $\mu$m, and more preferably 60 to 150 $\mu$m, from the viewpoint of the use of the laminate film of the claimed invention as a component of a film for semiconductor manufacturing.

In the resin composition forming the second layer are added various additives as needed in amounts that do not compromise the advantageous effects of the claimed invention. Specific examples of the additives include the same ones as those that may be added to a thermoplastic resin composition forming the outermost layer described below.

Thus, when the laminate film of the claimed invention having the second layer containing the resin composition containing the ethylene-unsaturated carboxylic acid copolymer excellent in stress relaxation properties or the ionomer thereof is used as a base film used in a film for semiconductor manufacturing, stress or the like loaded upon back surface grinding of a semiconductor wafer can be relaxed, thereby allowing the prevention of damage to the thinned semiconductor wafer.

(Outermost Layer)

The outermost layer in the laminated structure of the claimed invention is a layer positioned at the outermost side of the laminate film, and may be disposed only on one side of the laminate film (see FIG. 1) or on both sides thereof.

The outermost layer is formed of a thermoplastic resin composition containing a thermoplastic resin having a melting point of 98°C or higher. As described above, the outermost layer formed of a thermoplastic resin having a relatively high melting point, such as 98°C or higher, is hardly softened even by heat generated upon back surface grinding of a semiconductor wafer or by heat generated upon attachment of a dicing film. Accordingly, when the laminate film of the claimed invention having the outermost layer is used as a base film for a film for semiconductor manufacturing, detachment of the film after use is easy, and damage to a thinned semiconductor wafer can be prevented.

The melting point of the thermoplastic resin in the thermoplastic resin composition forming the outermost layer is preferably 98°C or higher, more preferably 102°C or higher, and still more preferably 105°C or higher, from the viewpoint of improving heat resistance of the laminate film. Particularly preferred is 120°C or higher. An upper limit value of the melting point of the thermoplastic resin is not specifically limited, but is preferably approximately 230°C.

The thickness of the outermost layer is not specifically limited, but is preferably 5 to 50 $\mu$m, from the viewpoint of the use of the laminate film of the claimed invention as a component of a film for semiconductor manufacturing.

When the resin composition forming the second layer contains the above-described ionomer, a Vicat softening temperature of the thermoplastic resin forming the outermost layer is preferably 70°C or higher, more preferably 80°C or higher, and particularly preferably 120°C or higher. By setting the Vicat softening temperature of the thermoplastic resin in the thermoplastic resin composition forming the outermost layer to 70°C or higher, the heat resistance of the laminate film can be further improved. An upper limit value of the Vicat softening temperature of the thermoplastic resin is not specifically limited, but is preferably approximately 160°C. The term "Vicat softening temperature" as used herein is a physical property value defined by JIS K7206.

When the resin composition forming the second layer contains the above-described ionomer, the melt flow rate (MFR) of the thermoplastic resin forming the outermost layer as measured in accordance with JIS K-6721 at 190°C under a load of 2.16 kg is preferably 0.1 to 60 g/min, and more preferably 0.3 to 30 g/min. The thermoplastic resin composition containing the thermoplastic resin having an MFR that falls within any of the above-described range exhibits good processability, e.g., by coextrusion molding with the resin composition for the ionomer-containing second layer and thus has the advantage of, for example, being easily processed into film.

When the resin composition forming the second layer contains the above-described ionomer, the kind of the thermoplastic resin forming the outermost layer is not specifically limited as long as it has the above-mentioned melting point. Preferred is a polyolefin or a polyester elastomer. Examples of the polyolefin include ethylene-unsaturated carboxylic acid copolymers such as ethylene-(meth)acrylic acid copolymer, low-density polyethylene (LDPE), linear low-density polyethylene (LLDPE), and polypropylene. Among them, ethylene-unsaturated carboxylic acid copolymers are preferable. Specific examples of the polyester elastomers include commercially available products, such as trade name "PELPRENE" series produced by Toyobo Co., Ltd., trade name "HYTREL" series produced by Toray-DuPont Co., Ltd., and trade name "PRIMALLOY" series produced by Mitsubishi Chemical Corporation. These thermoplastic resins may be used alone or in combination.

When the resin composition forming the second layer contains the above-described ionomer, the ethylene-unsaturated carboxylic acid copolymer that may be included in the outermost layer is a copolymer of ethylene and an unsaturated carboxylic acid such as (meth)acrylic acid. The percentage of structural units derived from the unsaturated carboxylic acid included in the ethylene-unsaturated carboxylic acid copolymer (i.e., unsaturated carboxylic acid content) is preferably 10wt% or less, and more preferably 9wt% or less. If the unsaturated carboxylic acid content is too high, the melting point of the ethylene-unsaturated carboxylic acid copolymer can be lowered (e.g., to less than 98°C).

When the resin composition forming the second layer contains the above-described copolymer, the MFR of the thermoplastic resin included in the thermoplastic resin composition forming the outermost layer is an important physical property value, from the viewpoint of stress relaxation properties and processability. The MFR of the thermoplastic resin is measured in accordance with JIS K-7210 at 190°C under a load of 2.16 kg, and is preferably 15 to 500 g/min, and more preferably 20 to 300 g/min.

The thermoplastic resin composition containing the thermoplastic resin having an MFR that falls within any of the above-described range exhibits good processability, e.g., by extrusion molding, and has the advantage of, for example, being easily processed at low temperatures. In addition, the thermoplastic resin composition is excellent also from the viewpoint of stress relaxation properties. On the other hand, a thermoplastic resin composition containing a thermoplastic resin having an MFR lower than the above-described range has the problem of reducing stress relaxation properties when combined with the second layer containing the above-described copolymer. A thermoplastic resin composition containing a thermoplastic resin having an MFR exceeding the above-described range makes it difficult to perform film molding by coextrusion molding with the resin composition for the second layer containing the copolymer.

When the resin composition forming the second layer contains the above-described copolymer, the kind of the thermoplastic resin forming the outermost layer is not specifically limited as long as it has a melting point of 98°C or higher; however, a polyolefin is preferable. Examples of the polyolefin having a melting point of 98°C or higher include ethylene-unsaturated carboxylic copolymers such as ethylene-(meth)acrylic acid copolymer, low-density polyethylene (LDPE), linear low-density polyethylene (LLDPE), and polypropylene. The polyolefin having a melting point of 98°C or higher is preferably polyethylene or an ethylene-unsaturated carboxylic acid copolymer.

When the resin composition forming the second layer contains the above-described copolymer, the ethylene-unsaturated carboxylic acid copolymer that may be included in the outermost layer is a copolymer of ethylene and an unsaturated carboxylic acid such as (meth)acrylic acid. The percentage of structural units derived from the unsaturated carboxylic acid included in the ethylene-unsaturated carboxylic acid copolymer (i.e., unsaturated carboxylic acid content) is preferably 10wt% or less, and more preferably 9wt% or less. If the unsaturated carboxylic acid content is too high, the melting point of the ethylene-unsaturated carboxylic acid copolymer can be lowered (e.g., to less than 98°C).

In all of the cases where the resin composition forming the second layer contains either the copolymer or the ionomer thereof, various additives are added as needed to the thermoplastic resin composition forming the outermost layer in amounts that do not compromise the advantageous effects of the claimed invention. Specific examples of the additives include UV absorbers, such as benzophenone UV absorbers, benzoate UV absorbers, benzotriazole UV absorbers, cyanoacrylate UV absorbers, and hindered amine UV absorbers; polymer antistatic agents; fillers such as silica, clay, calcium carbonate, barium sulfate, glass beads, and talc; flame retardants; antibacterial agents; and fungicides.

(Laminate Film)

When the above-described resin composition forming the second layer contains the above-described ionomer, the ratio of thickness (X) of the outermost layer to thickness (Y) of a layer other than the outermost layer (second layer) in the laminate film, the X/Y ratio, is preferably 5/95 to 45/55, more preferably 10/90 to 40/60, and particularly preferably 20/80 to 30/70. When the ratio of outermost layer thickness (X) to second layer thickness (Y) falls within any of the above-described ranges, heat resistance and stress relaxation properties can be more effectively exerted.

In this case, although the overall thickness of the laminate film is not specifically limited, it is preferably 65 to 200 $\mu$m, from the viewpoint of the use of the laminate film of the claimed invention as a component of a film for semiconductor manufacturing.

When the above-described resin composition forming the second layer contains the above-described ionomer, the total of the unsaturated carboxylic acid content of the thermoplastic resin in the thermoplastic resin composition forming the outermost layer plus the unsaturated carboxylic acid content of the ionomer in the thermoplastic resin composition forming the second layer (i.e. unsaturated carboxylic acid content in the entire laminate film) is preferably 12wt% or more, and more preferably 14 to 20wt% or more, with respect to the total amount of the resins forming the outermost layer and the second layer. By setting the unsaturated carboxylic acid content in the entire laminate film to 12wt% or more, excellent stress relaxation properties can be obtained.

When the above-described resin composition forming the second layer contains the above-described copolymer, the ratio of thickness (X) of the outermost layer to thickness (Y) of the second layer as a layer other than the outermost layer in the laminate film of the claimed invention, the X/Y ratio, is preferably 5/95 to 60/40, more preferably 7/93 to 50/50, and particularly preferably 10/80 to 40/60. When the outermost layer is disposed on both sides of the laminate film, the total thickness of those layers is set as (X). When the laminate film has two or more second layers, the total thickness of the layers is set as (Y). When the ratio of outermost layer thickness (X) to second layer thickness (Y) falls within any of the above-described ranges, heat resistance and stress relaxation properties can be more effectively exerted.

In this case, although the overall thickness of the laminate film is not specifically limited, it is preferably 65 to 200 $\mu$m, from the viewpoint of the use of the laminate film of the claimed invention as a component of a film for semiconductor manufacturing.

When the above-described resin composition forming the second layer contains the above-described copolymer, the ratio of a MFR-1 of the thermoplastic resin composition forming the outermost layer as measured at 190°C under a load of 2160 g to a MFR-2 of the ethylene-unsaturated carboxylic acid copolymer forming the second layer as measured at 190°C under a load of 2160 g, the MFR-1/MFR-2 ratio, is preferably 0.2 to 4, more preferably 0.3 to 3, and particularly preferably 0.5 to 2. When the ratio MFR-1/MFR-2 falls within any of the above-described ranges, the stress relaxation properties of the laminate film enhance. When the ratio MFR-1/MFR-2 is lower than the above-described range, molding (e.g., extrusion molding) of the laminate film can be difficult.

(Production of Laminate Film)

The laminate film of the claimed invention may be produced by any of the methods known in the art, such as extrusion method or lamination method. When the laminate film is produced by the lamination method, an adhesive may be interposed between the layers. The adhesive usable may be a conventionally known adhesive.

2. Film for Production of Semiconductor

Hereinafter, a film for semiconductor manufacturing of the claimed invention will be described. FIG. 2 is a cross-sectional view schematically illustrating an embodiment of a film for semiconductor manufacturing of the claimed invention. As shown in FIG. 2, film 20 for producing semiconductor of the present embodiment is provided with laminate film 10 and adhesive layer 15 that is disposed on a surface of laminate film 10 (i.e., a surface second layer 3) remote from outermost layer 6 of laminate film 10. As laminate film 10 above-described, the laminate film of the claimed invention described above is used.

The film for semiconductor manufacturing of the claimed invention has the laminate film of the claimed invention as a base film and additionally has an adhesive layer. The adhesive layer is disposed on a surface of the laminate film, which surface is remote from the outermost layer of the laminate film. Accordingly, the film for semiconductor manufacturing of the invention can be attached to a semiconductor wafer with the adhesive layer and is used as a film for semiconductor manufacturing. Specifically, the film for semiconductor manufacturing of the invention can be used as a back grinding film in the back-surface grinding of a semiconductor wafer and as a dicing film in semiconductor wafer dicing.

As described above, since the laminate film of the claimed invention shows excellent heat resistance and stress relaxation properties, the film for semiconductor manufacturing of the claimed invention also shows similarly excellent heat resistance and stress relaxation properties. Therefore, using the film for semiconductor manufacturing allows semiconductor wafer processing to be performed efficiently with high precision.

(Adhesive Layer)

The adhesive layer of the film for semiconductor manufacturing of the claimed invention is composed of an adhesive. To the adhesive layer is attached and fixed a semiconductor wafer that will be subjected to back-surface grinding or dicing processing. A thickness of the adhesive layer is preferably 3 to 100 $\mu$m, and more preferably 3 to 50 $\mu$m, although it depends on the kind of the adhesive.

As the adhesive used for the adhesive layer, any of the adhesives known in the art may be used. Examples of the adhesives include rubber adhesives, acrylic adhesives, silicone adhesives, and polyvinyl ether adhesives; radiation curable adhesives; and thermally foaming adhesives. Among them, preferably, the adhesive layer includes a UV curable adhesive, from the viewpoint of detachability of the film for semiconductor manufacturing from a semiconductor wafer.

Examples of the acrylic adhesives that may form the adhesive layer include homopolymers of (meth)acrylic acid esters, and copolymers of (meth)acrylic acid esters and copolymerizable monomers. Specific examples of the (meth)acrylic acid esters include methacrylic acid alkyl esters such as methyl methacrylate, ethyl methacrylate, butyl methacrylate, 2-ethylhexyl methacrylate, octyl methacrylate, and isononyl methacrylate; methacrylic acid hydroxyalkyl esters such as hydroxyethyl methacrylate, hydroxybutyl methacrylate, and hydroxyhexyl methacrylate; and methacrylic acid glycidyl esters.

Specific examples of the monomers copolymerizable with the (meth)acrylic acid esters include methacrylic acid, itaconic acid, maleic anhydride, (meth)acrylic amide, (meth)acrylic N-hydroxymethylamide, alkylaminoalkyl (meth) acrylates (e.g., dimethylaminoethyl methacrylate and t-butylaminoethyl methacrylate), vinyl acetate, styrene, and acrylonitrile.

The UV curable adhesive that may form the adhesive layer is not specifically limited, but includes any of the above-described acrylic adhesives, a UV curable component (i.e., component capable of adding a carbon-carbon double bond to a polymer side chain of an acrylic adhesive), and a photopolymerization initiator. To the UV curable adhesive may be added, as needed, additives such as crosslinking agents, tackifiers, fillers, anti-aging agents, and coloring agents.

The UV curable component included in the UV curable adhesive is, for example, a monomer, an oligomer or a polymer having a carbon-carbon double bond in a molecule thereof and curable by radical polymerization. Specific examples of the UV curable component include esters of (meth)acrylic acid and polyhydric alcohols, such as trimethylol propane tri(meth)acrylate, pentaerythritol tri(meth)acrylate, tetraethylene glycol di(meth)acrylate, 1,6-hexanediol (meth) acrylate, neopentyl glycol di(meth)acrylate, and dipentaerythritol hexa(meth)acrylate, and oligomers thereof; and isocyanurates such as 2-propenyldi-3-butenyl cyanurate, 2-hydroxyethylbis(2-acryloxylethyl)isocyanurate, tris(2-methacryloxyethyl)isocyanurate, and tris(2-methacryloxyethyl)isocyanurate.

Specific examples of the photopolymerization initiator included in the UV curable adhesive include benzoin alkyl ethers such as benzoin methyl ether, benzoin isopropyl ether, and benzoin isobutyl ether; aromatic ketones such as $\alpha$-hydroxycyclohexyl phenyl ketone; aromatic ketals such as benzyl dimethyl ketal; and thioxanthones such as chlorothioxanthone, dodecylthioxanthone, dimethylthioxanthone, and diethylthioxanthone.

Examples of the crosslinking agent included in the UV curable adhesive include polyisocyanate compounds, melamine resins, urea resins, polyamines, and carboxyl group-containing polymers.

Preferably, a separator is attached to a surface of the adhesive layer of the film for semiconductor manufacturing of the claimed invention. Attachment of the separator allows the surface of the adhesive layer to be kept smooth. In addition, the attachment the separator facilitates handling and transport of the film for semiconductor manufacturing, as well as allows label processing on the separator.

The separator may be paper, a film of synthetic resin such as polyethylene, polypropylene, or polyethylene terephthalate, or the like. In addition, the surface of the separator in contact with the adhesive layer may be subjected to release treatment such as silicone treatment or fluoride treatment, as needed, to increase releasability from the adhesive layer. A thickness of the separator is usually 10 to 200 $\mu$m, and preferably approximately 25 to 100 $\mu$m.

(Production of Film for Semiconductor Manufacturing)

The film for semiconductor manufacturing of the claimed invention may be produced, for example, by applying an adhesive or an adhesive composition on the surface of the laminate film (i.e., the surface of the layer positioned on the opposite side of the outermost layer) to form a coat layer and then drying the coat layer to form an adhesive layer. Alternatively, the film for semiconductor manufacturing may also be produced by coextrusion of materials forming the respective layers of the laminate film and a material forming the adhesive layer (i.e., coextrusion molding method). In addition, the adhesive layer may be formed by performing thermal crosslinking of an adhesive composition layer as needed.

Furthermore, a separator may be attached on a surface of the adhesive layer to obtain the film for semiconductor manufacturing.

Examples

The present invention will now be described in detail based on Examples, which however shall not be construed as limiting the scope of the invention thereto.

Test Methods

[Heat Resistance Test]

Each aluminium foil and each film produced in Examples or Comparative Examples were cut out into an elongated shape with a width of 6 cm and stacked to obtain a laminated structure. The film was cut out such that an elongated direction thereof was in TD direction. In addition, the aluminum foil and the film were stacked on each other such that an outermost layer of the film was in contact with the aluminium foil. The obtained laminated structures were covered with a fluorine resin film and pressurized using a heat seal bar (30 cm) under conditions shown below to obtain evaluation samples.

Pressure: 0.07 MPa
Seal bar width: 20 mm
Heat sealing time: 5 seconds
Seal bar temperature: 80°C

Using a tensile tester, adhesive strength (g/20 mm) between the aluminium foil and the film in the obtained evaluation samples was measured under the condition of a tensile rate of 300 mm/min. Based on the following criteria, "heat resistance" of each film was evaluated based on the measured adhesive strength.

A: less than 10 g/20 mm (not adhered).
B: 10 g/20 mm to less than 50 g/20 mm (manually detachable without feeling of resistance).
C: 50 g/20 mm to less than 100 g/20 mm (slight resistance upon detachment.)
D: 100 g/20 mm or more (strong resistance upon detachment.)

[Stress Relaxation Test]

The films produced in Examples or Comparative Examples were cut out to obtain sample pieces having a strip shape with a width of 10 mm. The obtained sample pieces were stretched under the conditions shown below to measure "tensile strength immediately after 10% stretch" and "tensile strength after one-minute retention in 10% stretch state".

Tensile rate: 200 mm/min
Chuck-to-chuck distance: 100 mm
Test sample (test piece) count: n = 5
Film direction: TD direction and MD direction

From the measured "tensile strength immediately after 10% stretch" and "tensile strength after one-minute retention in 10% stretch state", "stress relaxation rate (%)" of the films were calculated by formula (1) below. In addition, based on the following criteria, "stress relaxation properties" of the films were evaluated from the calculated stress relaxation rate.

$$\mathrm{Stress\ relaxation\ rate\ (\%)} = \{(TS_1 - TS_2)/TS_1\} \times 100\ (1)$$

$TS_1$: tensile strength immediately after 10% stretch
$TS_2$: tensile strength after one-minute retention in 10% stretch state

A: Stress relaxation rate is 55% or more for both TD and MD directions.
B: Stress relaxation rate is 50% to less than 55% for at least one of TD and MD directions.
D: Stress relaxation rate is less than 50% in both the TD direction and the MD direction.

As the tensile strength after one-minute retention in 10% stretch state becomes smaller, the stress relaxation rate becomes larger. When the tensile strength after one-minute retention in 10% stretch state is small, it means that permanent plastic deformation occurred in the sample piece and consumed a part of stress energy. Thus, sample pieces having "a large value of the stress relaxation rate" are evaluated as having tendency to absorb loaded stress owing to plastic deformation.

1. Production of Film (1)

Table 1 lists materials used as the resin material of the outermost layer. MFR values were measured at 190°C under a load of 2160 g.
Table 1

| | Methacrylic acid content (wt%) | Melting point (°C) | Vicat softening temperature (°C) | MFR (g/10 min) | Density (kg/m$^3$) |
|---|---|---|---|---|---|
| EMAA(1)*1 | 4 | 105 | 92 | 7 | - |
| EMAA(2)*1 | 15 | 93 | 63 | 25 | - |
| EMAA(3)*1 | 9 | 99 | 82 | 8 | - |
| Polyester elastomer (1)*2 | - | 182 | 127 | 0.3 | 1120 |
| Polyester elastomer (2)*3 | - | 160 | 74 | 13 | 1070 |
| LDPE *4 | - | 106 | 86 | 7.2 | 917 |
| LLDPE*5 | - | 98 | 83 | 3.8 | 903 |
| *1: Ethylene-methacrylic acid random copolymer produced by Mitsui-DuPont Polychemicals Co., Ltd. | | | | | |
| *2: Trade name "HYTREL 4047" produced by Toray-DuPont Co., Ltd. | | | | | |
| *3: Trade name "HYTREL 3046" produced by Toray-DuPont Co., Ltd. | | | | | |

Table 2 lists materials used as the resin material of the second layer.

Table 2

| | Methacrylic acid content (wt%) | Kind of metal | Ratio of crosslinked carboxyl groups (mol%) | MFR (g/10 min) |
|---|---|---|---|---|
| EMAA-IO(1)*1 | 17.5 | Zn | 21 | 10 |
| EMAA-IO(2)*1 | 20 | Zn | 17 | 10 |
| EMAA-10(3)*1 | 15 | Zn | 23 | 5 |
| *1: Ionomer of ethylene-methacrylic acid random copolymer produced by Mitsui-DuPont Polychemicals Co., Ltd. | | | | |

(Example 1)

Using, as the material of the outermost layer, EMAA (1) (ethylene-methacrylic acid random copolymer produced by Mitsui-DuPont Polychemicals Co., Ltd) shown in Table 1 and, as the material of the second layer, EMAA-IO (1) (a zinc (Zn) ionomer of the ethylene-methacrylic acid random copolymer produced by Mitsui-DuPont Polychemicals Co., Ltd) shown in Table 2, extrusion molding was performed by a multi-layer extruder (40 mm-diameter x 3) to obtain a laminate film (thickness ratio of the outermost layer to the second layer = 30/70) with a thickness of 160 µm having a double-layer structure. An evaluation result on heat resistance of the obtained laminated film was "A" and an evaluation result on stress relaxation properties thereof was "B".

(Examples 2 to 9 and Comparative Examples 1 to 7)

(Laminate) films were obtained in the same manner as in Example 1 described above, except that the materials of the outermost layer and the second layer and the thickness ratio of the outermost layer to the second layer were set as shown in Table 3. Table 3 shows evaluation results on heat resistance and stress relaxation properties of the obtained (laminate) films.

Table 3

| | Layer structure | Material | | Thickness ratio (outermost layer (X) /second layer (Y)) | Methacrylic acid content[1] (wt%) | Evaluation | |
| | | Outermost layer | Second layer | | | Heat resistance | Stress relaxation properties |
|---|---|---|---|---|---|---|---|
| Example 1 | Double layer | EMAA(1) | EMAA-IO(1) | 30/70 | 15.2 | A | B |
| Example 2 | Double layer | EMAA(3) | EMAA-IO(2) | 30/70 | 16.7 | B | B |
| Example 3 | Double layer | EMAA(1) | EMAA-IO(2) | 30/70 | 15.2 | B | B |
| Example 4 | Double layer | Polyester elastomer (1) | EMAA-IO(2) | 20/80 | 16 | A | A |
| Example 5 | Double layer | Polyester elastomer (2) | EMAA-IO(2) | 10/90 | 18 | B | A |
| Example 6 | Double layer | LLDPE | EMAA-IO(2) | 10/90 | 18 | A | A |
| Example 7 | Double layer | LLDPE | EMAA-IO(2) | 20/80 | 16 | A | A |
| Example 8 | Double layer | LDPE | EMAA-IO(2) | 20/80 | 16 | A | A |
| Example 9 | Double layer | LDPE | EMAA-IO(2) | 30/70 | 14 | A | B |
| Comparative Example 1 | Single layer | EMAA(1) | - | - | 4 | A | D |
| Comparative Example 2 | Single layer | EMAA(2) | - | - | 15 | D | B |
| Comparative Example 3 | Single layer | EMAA(3) | - | - | 9 | C | D |
| Comparative Example 4 | Double layer | EMAA(1) | EMAA-IO(3) | 10/90 | 13.9 | B | D |
| Comparative Example 5 | Double layer | EMAA(1) | EMAA-IO(3) | 30/70 | 11.7 | B | D |
| Comparative Example 6 | Double layer | EMAA(1) | EMAA(2) | 35/65 | 11.2 | B | D |
| Comparative Example 7 | Double layer | Polyester elastomer (1) | EMAA(2) | 30/70 | 10.5 | A | D |
| [1]: Content in the entire film | | | | | | | |

[Evaluation]

From the results shown in Table 3, the laminate films of Examples 1 to 9 are excellent in heat resistance and stress relaxation properties as compared to the (laminate) films of Comparative Examples 1 to 7. In addition, when the second layer is composed of an ionomer of EMAA having a methacrylic acid content of 17wt% or more (Example 1), the film is excellent in stress relaxation properties as compared to cases in which the second layer is composed of an ionomer of EMAA having a methacrylic acid content of less than 17wt% (Comparative Examples 4 and 5).

Even when the outermost layers are composed of the same material, evaluation results on heat resistance were different. The reason for this is considered to be due to differences in outermost layer thickness (e.g., between Example 1 and Comparative Example 4) and/or differences in material composition of the second layer that is in contact with the outermost layer (e.g., between Example 1 and Example 3). That is, it is obvious that the heat resistance and the stress relaxation properties of the laminate film are determined not only by the physical properties of the respective layers forming the laminate film but also by the thicknesses of the respective layers and the combination of the layers.

2. Production of Film (2)

Table 4 lists materials used as the resin material of the outermost layer. MFR values were measured at 190°C under a load of 2160 g.

Table 4

| | Melting point (°C) | MFR (g/10 min) | Vicat softening point (°C) | Density (kg/m$^3$) |
|---|---|---|---|---|
| LDPE(1)[*1] | 102 | 60 | 76 | 915 |
| LDPE(2)[*1] | 106 | 7.2 | 86 | 917 |
| LLDPE[*2] | 123 | 50 | 112 | 926 |
| PP[*3] | 148 | 19 | 123 | 900 |
| *1: Low density polyethylene produced by Mitsui-DuPont Polychemicals Co., Ltd. *2: Linear low density polyethylene: trade name "NEO-ZEX 25500J" produced by Prime Polymer Co., Ltd. *3: Polypropylene: trade name "PRIME POLYPRO J229E" produced by Prime Polymer Co., Ltd. | | | | |

Table 5 shows materials used as the resin material of the second layer.

Table 5

| | Methacrylic acid content (wt%) | Melting point (°C) | MFR (g/10 min) |
|---|---|---|---|
| EMMA(1)[*4] | 20 | 87 | 60 |
| EMMA(2)[*4] | 15 | 93 | 60 |
| *4: Ethylene-methacrylic acid random copolymer produced by Mitsui-DuPont Polychemicals Co., Ltd. | | | |

[Example 10]

The material of the outermost layer used was LDPE (1) (low density polyethylene; see Table 4), and the material of the second layer used was EMMA (1) (ethylene-methacrylic acid random copolymer; see Table 5). Using a multi-layer extruder (40 mm-diameter x 3), coextrusion molding was performed at a resin temperature of 140°C to obtain a laminate film with a thickness of 150 μm having a double layer structure (thickness ratio of the outermost layer to the second layer = 10/90).

[Examples 11 to 15]

Laminate films composed of the outermost layers and the second layers shown in Table 6 were molded by coextrusion molding. The same conditions as those in Example 1 described above were used except that the materials of the outermost layer and the second layer and the thickness ratio of the outermost layer to the second layer were set as shown in Table 6.

[Comparative Examples 8 to 12]

In Comparative Examples 8 to 10, the single layer films shown in Table 6 were molded by extrusion molding, and in Comparative Examples 11 to 12 the laminate films composed of the outermost layers and the second layers shown in Table 6 were molded by coextrusion molding. The conditions were the same as those in Example 1 described above except that the materials of the outermost layer and the second layer and the thickness ratio of the outermost layer to the second layer were set as shown in Table 6.

Evaluation was made through the above-described steps regarding the heat resistance and the stress relaxation properties of the single layer films or the laminate films obtained in the Examples and the Comparative Examples. Table 6 shows the evaluation results. The values of stress relaxation properties were measured by the above-described method, for both TD and MD directions.

Table 6

| | Layer structure | Material | | Thickness ratio [outermost layer (X) /second layer (Y) /outermost layer (X)] | MFR ratio outermost layer/second layer | Evaluation | |
| --- | --- | --- | --- | --- | --- | --- | --- |
| | | Outermost layer | Second layer | | | Heat resistance | Stress relaxation properties (MD/TD) |
| Example 10 | Double layer | LDPE(1) | EMMA(1) | 10/90/- | 1 | A | 65/65 |
| Example 11 | Double layer | LDPE(1) | EMMA(1) | 20/80/- | 1 | A | 62/62 |
| Example 12 | Double layer | LLDPE | EMMA(1) | 10/90/- | 1 | A | 64/64 |
| Example 13 | Triple layer | LDPE(1) | EMMA(1) | 10/80/10 | 1 | A | 63/63 |
| Example 14 | Double layer | PP | EMMA(1) | 10/90 | 0.33 | A | 61/60 |
| Comparative Example 8 | Single layer | EMMA(1) | - | - | | C | 64/64 |
| Comparative Example 9 | Single layer | EMMA(2) | - | - | | D | 50/49 |
| Comparative Example 10 | Single layer | LDPE(1) | - | - | | A | 19/19 |
| Comparative Example 11 1 | Double layer | LDPE(2) | EMMA(1) | 10/90 | 0.12 | -* | -* |
| Comparative Example 12 | Double layer | LDPE(1) | EMMA(2) | 10/90 | 1 | A | 48/48 |
| Example 15 | Double layer | LDPE(1) | EMMA(1) | 50/50 | 1 | A | 50/49 |
| *: Film processing was impossible. | | | | | | | |

[Evaluation]

From the results shown in Table 6, it can be seen that the laminate films of Examples 10 to 15 were excellent in heat resistance and showed stress relaxation properties of 61% or more.

In contrast, the single layer films of Comparative Examples 8 and 9 were poor in heat resistance. Meanwhile, the single layer film of Comparative Example 10 was excellent in heat resistance, but very low in stress relaxation properties. Regarding the laminate film of Comparative Example 11, film processing was impossible. This is due to that the ratio of an MFR (7.2 g/10 min) of polyethylene forming the outermost layer with respect to an MFR (60 g/10 min) of the ethylene-methacrylic acid random copolymer forming the second layer is too small (0.12).

In Comparative Example 12 in which the methacrylic acid content of the ethylene-methacrylic acid random copolymer forming the second layer was less than 17wt% (15wt%), stress relaxation properties were reduced as compared to Example 10 in which the methacrylic acid content of the ethylene-methacrylic acid random copolymer forming the second layer was 20wt%.

Thus, to obtain a laminate film that achieves both heat resistance and stress relaxation properties, it is necessary to adjust not only the physical properties of the respective layers but also the thicknesses of the respective layers, the thickness ratio thereof, and the like.

Industrial Applicability

The laminate film of the claimed invention is excellent in heat resistance and stress relaxation properties. Therefore, using the laminate film and the film for semiconductor manufacturing of the claimed invention allows a semiconductor wafer to be processed efficiently with high precision to produce semiconductors.

Reference Signs List

| | |
|---|---|
| 3 | Second layer |
| 6 | Outermost layer |
| 10 | Laminate film |
| 15 | Adhesive layer |
| 20 | Film for manufacturing semiconductor |

**Claims**

1. A laminate film comprising a laminated structure composed of at least two layers including an outermost layer, wherein:

    the outermost layer comprises a thermoplastic resin composition containing a thermoplastic resin having a melting point of 98°C or higher; and
    at least one layer other than the outermost layer comprises a resin composition containing at least one of an ethylene-unsaturated carboxylic acid copolymer having an unsaturated carboxylic acid content of 17wt% or more and an ionomer of the ethylene-unsaturated carboxylic acid copolymer.

2. The laminate film according to claim 1, wherein the resin composition contained in the at least one layer other than the outermost layer contains an ionomer of the ethylene-unsatured carboxylic acid copolymer.

3. The laminate film according to claim 2, wherein a Vicat softening temperature of the thermoplastic resin is 70°C or higher.

4. The laminate film according to claim 2, wherein the thermoplastic resin is one of a polyolefin and a polyester elastomer.

5. The laminate film according to claims 2, wherein a ratio of thickness (X) of the outermost layer to thickness (Y) of the at least one layer other than the outermost layer is 5/95 to 45/55.

6. The laminate film according to claim 1, wherein the resin composition contains the ethylene-unsaturated carboxylic acid copolymer.

7. The laminate film according to claim 6, wherein an MFR of the thermoplastic resin, as measured at 190°C under a load of 2160 g, is 15 g/10 min or more.

8. The laminate film according to claim 6, wherein an MFR of the ethylene-unsaturated carboxylic acid copolymer, as measured at 190°C under a load of 2160 g, is 15 g/10 min or more.

9. The laminate film according to claim 6, wherein a ratio of thickness (X) of the outermost layer to total thickness (Y) of layers containing the ethylene-unsaturated carboxylic acid copolymer is 5/95 to 60/40.

10. The laminate film according to claim 9, wherein a ratio of a MFR-1 as measured at 190°C under a load of 2160 g of the thermoplastic resin composition forming the outermost layer to a MFR-2 as measured at 190°C under a load of 2160 g of the ethylene-unsaturated carboxylic acid copolymer is in a range of 0.2 to 5.

11. The laminate film according to claim 6, wherein the thermoplastic resin composition forming the outermost layer includes polyethylene.

12. The laminate film according to claim 6, wherein the thermoplastic resin composition forming the outermost layer includes polypropylene.

13. A film for semiconductor manufacturing, comprising:

the laminate film according to claim 1; and
an adhesive layer disposed on a surface of the laminate film, the surface being remote from the outermost layer of the laminate film.

14. The film for semiconductor manufacturing according to claim 13, which is a back grinding film.

15. The film for semiconductor manufacturing according to claim 13, which is a dicing film.

FIG. 1

FIG. 2

<table>
<tr><td colspan="2" align="center">**INTERNATIONAL SEARCH REPORT**</td><td>International application No.<br>PCT/JP2011/004287</td></tr>
</table>

| | |
|---|---|
| A. CLASSIFICATION OF SUBJECT MATTER<br>*H01L21/304*(2006.01)i, *C09J7/02*(2006.01)i, *H01L21/301*(2006.01)i | |

According to International Patent Classification (IPC) or to both national classification and IPC

B. FIELDS SEARCHED

Minimum documentation searched (classification system followed by classification symbols)
H01L21/304, C09J7/02, H01L21/301

Documentation searched other than minimum documentation to the extent that such documents are included in the fields searched
Jitsuyo Shinan Koho          1922–1996   Jitsuyo Shinan Toroku Koho    1996–2011
Kokai Jitsuyo Shinan Koho    1971–2011   Toroku Jitsuyo Shinan Koho    1994–2011

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y<br>A | JP 2008-60151 A   (Nitto Denko Corp.),<br>13 March 2008 (13.03.2008),<br>paragraphs [0003], [0041] to [0054]<br>& US 2008/0057216 A1      & EP 1895581 A2<br>& CN 101136329 A          & KR 10-2008-0020540 A | 1-14<br>15 |
| Y<br>A | JP 2010-40568 A   (Achilles Corp.),<br>18 February 2010 (18.02.2010),<br>claims<br>(Family: none) | 1-14<br>15 |
| Y | JP 2009-141023 A  (The Furukawa Electric Co.,<br>Ltd.),<br>25 June 2009 (25.06.2009),<br>paragraph [0006]<br>(Family: none) | 3 |

☒  Further documents are listed in the continuation of Box C.          ☐  See patent family annex.

| | |
|---|---|
| *    Special categories of cited documents:<br>"A"  document defining the general state of the art which is not considered to be of particular relevance<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| | |
|---|---|
| Date of the actual completion of the international search<br>19 October, 2011 (19.10.11) | Date of mailing of the international search report<br>01 November, 2011 (01.11.11) |
| Name and mailing address of the ISA/<br>Japanese Patent Office | Authorized officer |
| Facsimile No. | Telephone No. |

Form PCT/ISA/210 (second sheet) (July 2009)

| INTERNATIONAL SEARCH REPORT | International application No. |
|---|---|
| | PCT/JP2011/004287 |

C (Continuation).    DOCUMENTS CONSIDERED TO BE RELEVANT

| Category* | Citation of document, with indication, where appropriate, of the relevant passages | Relevant to claim No. |
|---|---|---|
| A | JP 2010-74136 A  (Hitachi Chemical Co., Ltd.), 02 April 2010 (02.04.2010), entire text (Family: none) | 15 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 4351487 B

- JP 2009231700 A